# EUROPEAN PATENT SPECIFICATION

(11) **EP 2 381 502 B1**
(45) Date of publication and mention of the grant of the patent: **14.08.2013**
(21) Application number: 10004346.2
(22) Date of filing: 23.04.2010
(51) Int. Cl.: H01L 51/50

(54) **Organic semiconducting layer**
Organische Halbleiterschicht
Couche à semi-conducteur organique

(43) Date of publication of application: 26.10.2011
(73) Proprietor: Novaled AG, 01307 Dresden (DE)
(72) Inventor: Lux, Andrea, 01277 Dresden (DE); Werner, Ansgar, 01277 Dresden (DE); Rothe, Carsten, 01326 Dresden (DE)
(74) Representative: Bittner, Thomas L.

(56) References cited:
- EP-A1- 2 161 272
- EP-A2- 1 097 980
- LEE ET AL: "Efficient electron injection in organic light-emitting diodes using lithium quinolate/Mg:Ag/Al cathodes" JOURNAL OF INDUSTRIAL AND ENGINEERING CHEMISTRY, THE KOREAN SOCIETY OF INDUSTRIAL AND ENGINEERING CHEMISTRY, KOREA LNKD- DOI:10.1016/J.JIEC.2008.04.007, vol. 14, no. 5, 1 September 2008 (2008-09-01), pages 676-678, XP025694632 ISSN: 1226-086X [retrieved on 2008-09-01]

## Description

The present invention relates to an organic semiconducting layer and to an organic electronic device comprising such layer.

### Field of the invention

Organic semiconductors can be used to fabricate simple electronic components e.g. resistors, diodes, field effect transistors, and also optoelectronic components like organic light emitting devices (e.g. OLED organic light emitting diodes), and many others. The industrial and economical significance of the organic semiconductors and their devices is reflected in the increased number of devices using organic semiconducting active layers and the increasing industry focus on the subject.

A simple OLED is demonstrated in US4356429A. There, between conductive electrodes, two semiconductive organic layers are brought together: one transporting holes and the other one transporting electrons. The recombination of holes and electrons forms excitons in one or both of the organic layers, the excitons are eventually emitted following the spin statistics. Excitons with triplet spin can also be harvested by using the materials and techniques described in EP1705727. More elaborated OLEDs are described in EP1804309 and US2008182129. Nowadays the OLEDs have separated transport and emitter layers.

Such organic semiconducting layers mainly comprise conjugated organic compounds, which can be small molecules, for instance monomers, or oligomers, polymers, copolymers, copolymers of conjugated and non-conjugated blocks, completely or partially cross-linked layers, aggregate structures, or brush like structures. A device made with different types of compounds, in different layers or mixed together, for example with polymer and small molecule layers, is also called a polymer - small molecule hybrid device.

EP 1 097 980 A2 discloses bathophenanthroline compounds which arc adapted for use in organic electroluminescent devices, such as organic electroluminescent devices suitable as a display device or a light-emitting device.

EP 2 161 272 A1 discloses phenanthroline compounds and electroluminescent devices comprising the phenanthroline compounds, wherein the phenanthroline compounds may function as electron transport layers, as hole blocking layers or as hosts for phosphorescent emitter materials to provide electroluminescent devices.

J.Y. Lee, Journal of Industrial and Engineering Chemistry 14 (2008) 676-678, discloses a cathode structure of lithium quinolate and investigates the performance in an organic light-emitting diode on the basis of the thickness of a Mg:Ag interlayer between Liq and A1.

Organic electronic semiconductors can be used in organic electronic devices, and in organic-inorganic hybrid devices.

### Background of the invention

Despite the large electronic gap, usually up to 3 eV, formed between the highest occupied molecular orbital (HOMO) and the lowest unoccupied molecular orbital (LUMO) of the molecule, it is normally still low enough such that both positive and negative charge carriers can be injected by special electrodes. It is especially difficult to provide a suitable cathode for organic semiconducting layers, because the LUMO energy is very high, in a region in which the cathode is usually highly reactive to oxidation by oxygen or moisture. There are several solutions for electron injection in electron transport layers (ETL), typically a low work-function metal is used in the cathode, such as Ca, or Mg. Alternatively, electrically doped electron transport layers are used, the large density of charge carriers provided by the dopants forces moves the Fermi level of the ETL close to the LUMO, facilitating the electron injection due to the Fermi level alignment with the cathode. Another solution is the use of electron injection layers (EIL), such as a thin insulating layer, which decouples the Fermi level of the cathode from the Fermi level of the ETL, creating a thin barrier which can be tunneled.

However all these approaches have disadvantages, the low work-function materials used for the cathode are very unstable and the OLEDs tend to have a short lifetime. Furthermore, these materials are difficult to be handled during production. Also, the electrical doping requires very reactive materials such as Li or Cs, not only are these materials difficult to handle during production, but they also are required in high concentration, which decreases the required transparency of the ETL. Molecular dopants do not require high concentration, however there are only a very few known molecules with a very low ionization potential which is required for electrical dopants. As with the inorganic dopants, those molecular dopants are also highly reactive towards moisture and oxygen requiring special handling procedures. ElLs have the disadvantage that the additional barrier increases the operating voltage of the device. By using ElLs it is also required that the adjacent ETL has a very high mobility, otherwise an additional voltage loss over the undoped ETL further increases the operating voltage of the device.

### Summary of the invention

The problem to be solved is how to efficiently inject electrons into an ETL, without compromising the ETL's transparency, transport properties, and operation stability (lifetime).

It is an object of the present invention to provide an organic semiconducting layer, especially an electron transport layer, which overcomes the drawbacks of the prior art, especially to provide a layer without compromising the ETLs transparency, transport properties, and operation stability (lifetime).

It is a further object to provide a layer sequence and an OLED comprising such an organic semiconducting layer.

This object is achieved by the organic semiconducting layer according to claim 1, and the layer sequence and OLED according to claims 11 and 13, respectively. Preferred embodiments are disclosed in the sub claims.

In the formulas given in the claims, i.e. formula (1), (1a), (1b) and (2), any structural elements can be substituted by suitable substituents, whenever such a substitution is possible at all. For example if somebody select for R³ in formula (1) C₁-C₂₀-alkenyl, this alkenyl compound can be, of course, substituted by one or more suitable radicals.

Phenanthroline and derivatives thereof are frequently used electron transport materials (ETM) for ETLs. These materials have a reasonable LUMO and electron mobility and behave rather well with injection layers. Compounds like BPhen and BCP are also used in conjunction with dopants such as Cs. When doped with Cesium, BPhen allows to make OLEDs with minimal operating voltage. Despite the relatively high electron mobility, however, the operating voltage of OLEDs using undoped BPhen is considerably increased compared to the doped reference device. Example of such ETMs are given in US2009001327, US 2008227979. Although these materials are some of the best available options for ETM, the performance is not good enough and OLEDs with such materials suffer from considerable voltage loss and power efficiency loss.

It was now surprisingly found that compounds according to Formula 1 do extraordinarily improve the performance of an OLED. More surprisingly is that very similar compounds such as 2,4,7,9-tetraphenyl-1,10-phenanthroline, 2,9-dimethyl-4,7-diphenyl-1,10-phenanthroline, or 4,7-diphenyl-1,10-phenanthroline have very poor performance as further described below.

The inventive organic semiconducting layer comprises an electron transport material according to Formula (1) and an electron injecting material (EIM) according to Formula (2). In one embodiment the organic semiconducting layer comprises the ETM and the EIM mixed in a single layer. Preferentially, the concentration of the EIM in the ETL is between 27-75 weight%. It should be noted that the EIM according to the formula (2) is not a dopant like Li or Cs, or an electrical dopant mentioned above. Those EIM materials do not have electron donating character and are thereby air stable and easy to handle compared to electrical dopants.

In an additional embodiment the inventive layer comprises two sublayers, wherein the first sublayer comprises the ETM and the second sublayer comprises the EIM. Preferentially, the ETM is the main component in the first sublayer and the EIM is the main component of the second sublayer.

Alternatively the first sublayer contains ETM, and the EIM contains EIM only. In this embodiment, it is preferred that the first sublayer thickness is less or equal to 50 nm, more preferably less or equal to 30 nm. It is also preferred that the second sublayer thickness is between ≥0.5 and ≤3 nm. Thicker ETL and/or EIL layers could increase the operating voltage by more than 0.5 V. An advantage of this layer is that it does not require co-evaporation for its deposition (as required for electrical doping).

Optionally, the first sublayer comprises the ETM and also comprises the EIM in one single mixed layer, preferentially in a smaller portion, more preferentially less than 30mol%. In this embodiment, the first sublayer can be thicker, and it is preferred that the first sublayer thickness is between ≥5 nm and ≤70 nm.

It is preferable that the inventive semiconducting layer contains only two materials, namely the ETM and EIM.

As a preferred electron transport material 2,9-di(biphenyl-4-yl)-4,7-diphenyl-1,10-phenanthroline can be used.

Further preferred electron transport material can be taken from the following examples:

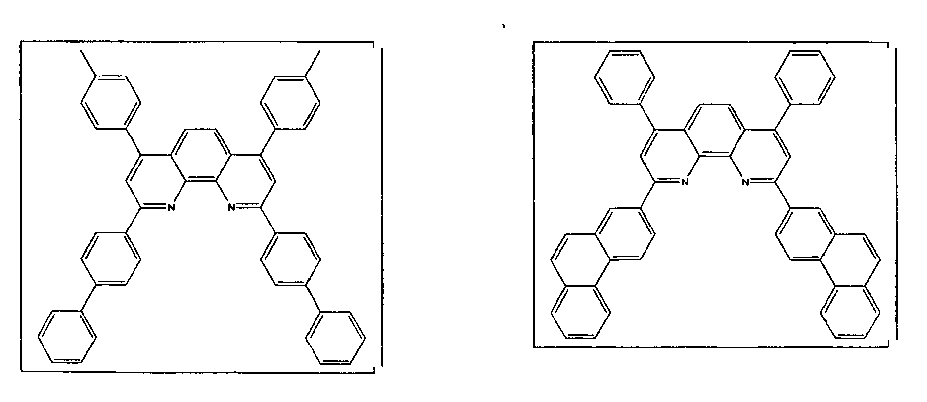

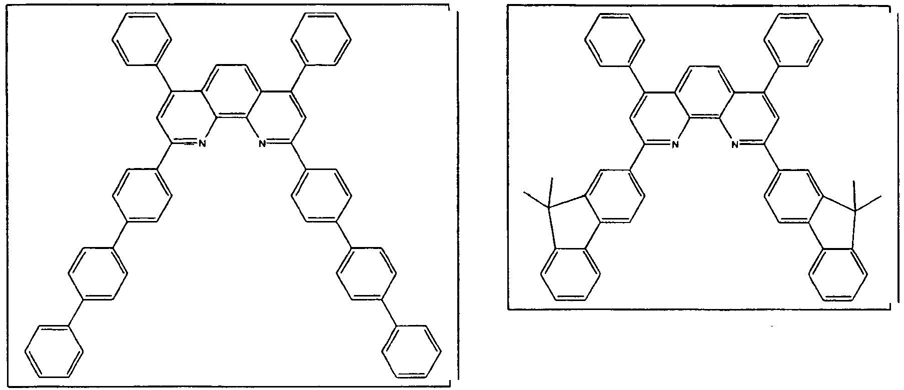

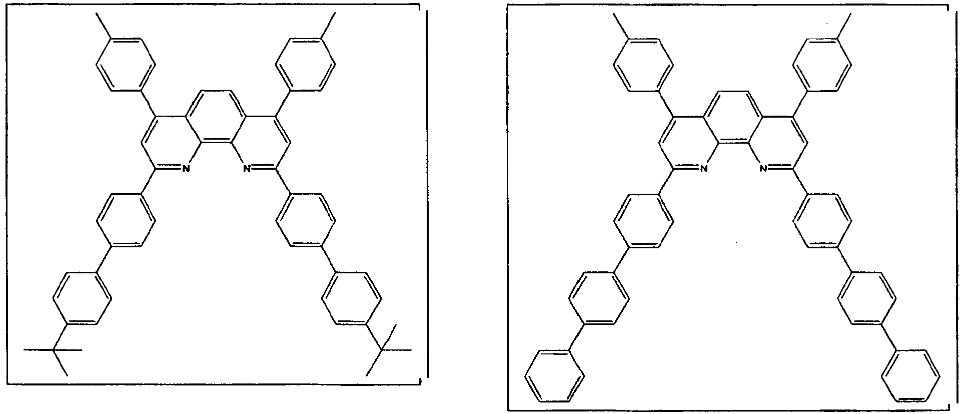

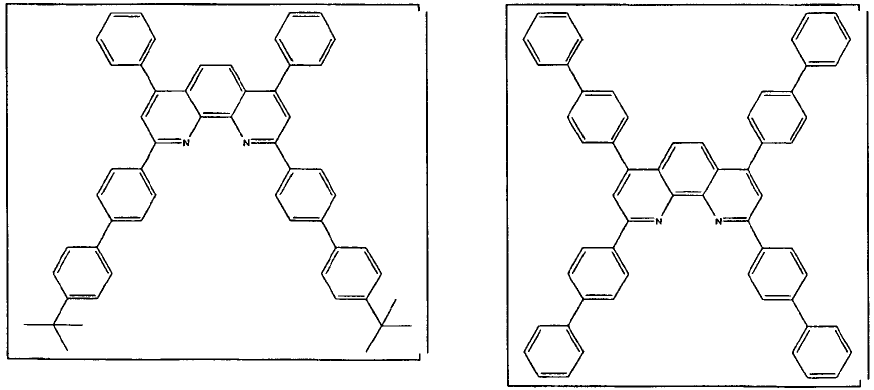

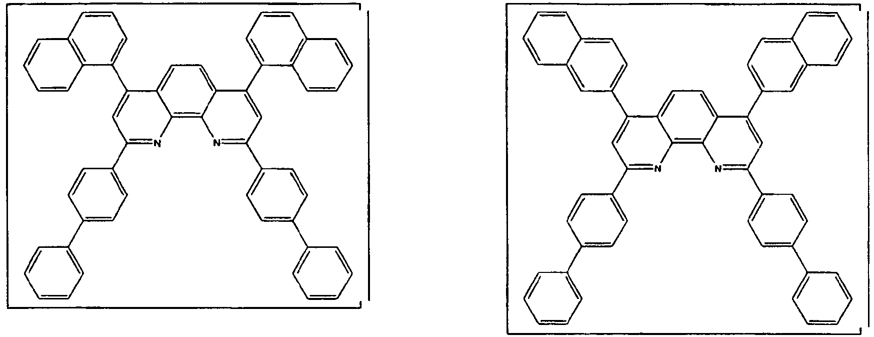

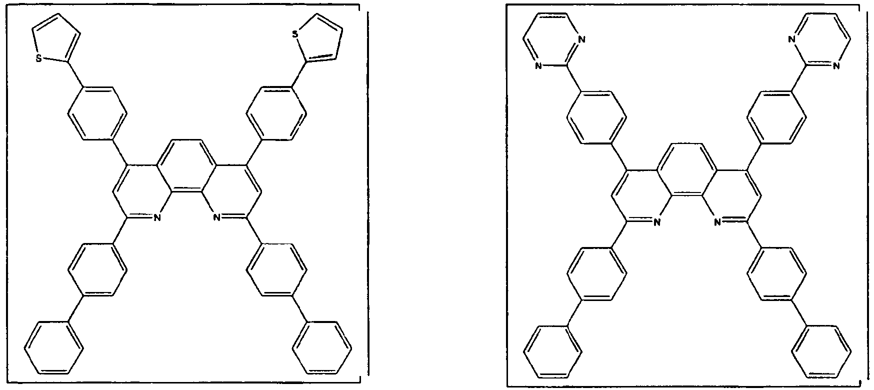

Further preferred the electron injecting materials can be selected from:

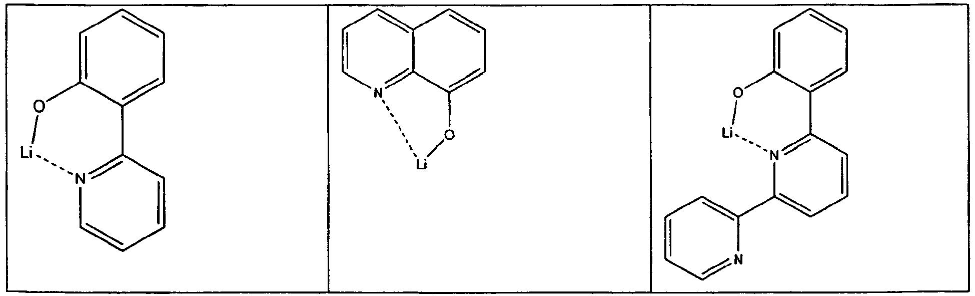

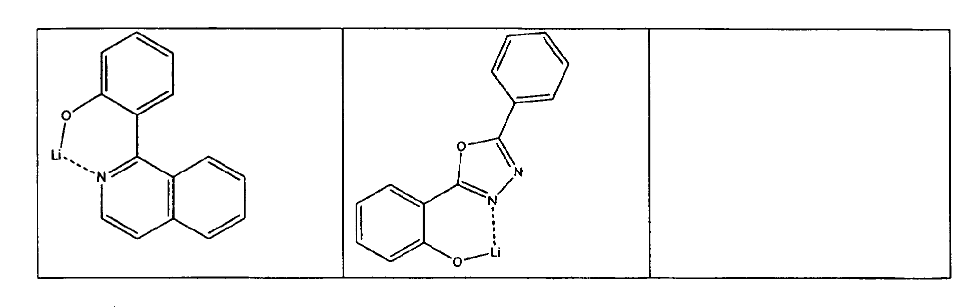

also preferred are 2,3-diphenyl-5-hydroxyquinoxalinolato lithium, cesium quinolate, potassium quinolate, rubidium quinolate. Additional information of such materials can be found in Jpn. J. Appl. Phys. 45 (2006) pp. L1253-L1255; Liang, Journal of Materials Chemistry v.13, pp. 2922-2926 (2003); Pu et al, 10, pp-228-232, Organic Electronics (2009).

### Layer stack (sequence) and organic light emitting diode

A further development of the invention is a stack of layers comprising the inventive semiconducting layer as described above wherein a metal cathode is provided in direct contact with the electron injecting material.

It is preferred that the cathode comprises a metal selected from: Mg, Ca, Ba, Al. Those materials provide best performance as cathode.

It is further preferred that the cathode comprises Al with a purity higher or equal to 99.95%. This embodiment enables the use of a very simple cathode whereas otherwise, Ca/Al, Mg/Al or alloys with a few percent of low work function materials in Al or Ag are necessary to achieve a good injection in non-doped ETLs.

In a preferred embodiment of the invention an OLED is provided comprising: an anode, an emitter layer, and a stack of layers as described above.

Preferably the OLED structure is a non-inverted structure, comprising: an anode provided over a substrate, an emitter layer provided over the anode, the inventive semiconducting layer provided over the emitter layer, and the cathode provided over the inventive semiconducting layer.

With this combination comprising the electron transport material (ETM) and electron injecting material (EIM) it is possible to achieve exceptionally good results. OLEDs according to the invention have better performance to state of the art OLEDs using injection layers. For instance, contrary to the expectations of Pu (see Pu et al, 10, pp-228-232, Organic Electronics (2009)), we obtain very good OLED performance with the invented EIM and ETM. The performance of the invented OLEDs is almost comparable to that of the best state of the art OLEDs, which are OLEDs with n-doped ETLs. The voltage of the inventive OLEDs is very low, and the operational stability is very high. These surprisingly good results were not expected with the ETMs according to the invention, since other, state of the art, ETMs do not show such properties even though some of them are of rather similar chemical structure (comparative examples below). Other advantages over the prior art are: the EIM is less reactive to atmospheric air and other impurities compared to electrical dopants; the EIM according to the invention can easily be evaporated from a normal thermal evaporation source, similar or identical to the one used for transport materials.

### Short description of the figures

Additional advantages and features of the present invention can be taken from the attached drawings which are not to be taken to restrict the scope of protection which is only to be defined by the appending claims.
Fig. 1 shows a stack (sequence) of layers according to the invention.
Fig. 2 shows a layer structure of an inventive OLED.
Figs. 3 to 6 show experimental data which are further explained below.

### Further description of the invention

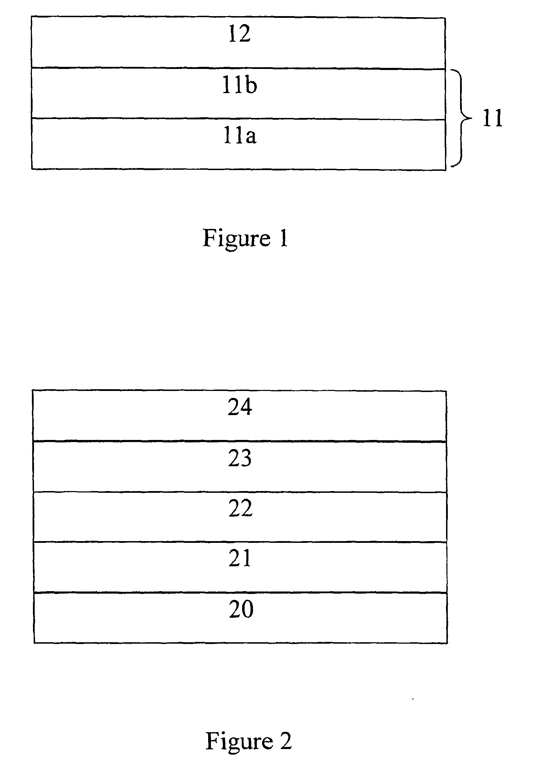

Figure 1 shows a layer stack (sequence) according to the invention. This stack is preferentially a closed layer sequence, meaning that there is no additional layer between sublayers (11a) and (11b), and between layers (11b) and (12). Preferentially there are also no further sublayers. Sublayers (11a) and (11b) form the inventive layer where layer (11a) is the electron transporting layer which, in one embodiment, comprises as its main component the electron transporting material as described above. Layer (11b) is the electron injecting layer comprising as its main component the electron injecting material as described above. Layer (12) is the cathode. In another embodiment the sublayers (11 a) may also comprise the EIM, preferentially in a smaller concentration than the ETM. In another optional embodiment, layers (11a) and (11b) may be one single layer comprising the EIM and the ETM, wherein ETM is preferentially the main component of the layer.

Figure 2 shows an OLED comprising a substrate (20), an anode (21), a layer according to the invention (23), a cathode (24), and a further layer (21) which comprises at least one light emitting layer. Layer (23) is preferably layer (11) as described in Fig. 1. The OLED can comprise additional layers. Typically, the additional layers are hole transport layers, charge blocking layers, charge generation layers, and others.

### Examples

Here follows a summary of the performance and lifetime data comparing an ETM according to the invention with typical state-of-the-art ETMs.

### Example 1:

Generic OLED stack: glass / ITO (90nm) / p-dopant:NPD (30nm, 3 wt%) / NPD (10nm) /blue doped Emitter layer (20nm) / Electron transport material (30nm) / LiQ (2 nm) /Aluminum (100 nm). NPD is N,N'-Bis(naphthalen-1-yl)-N,N'-bis(phenyl)-benzidine.

**Table 1.**

| ETM | Voltage/V At 10 mA/cm^2 | Current Efficiency (cd/A) at 1000 cd/m^2 | Power Efficiency (lm/W) at 1000 cd/m^2 | Quantum Efficiency At 1000 cd/m^2 |
|---|---|---|---|---|
| M1 (2,9-di(biphenyl-4-yl)-4,7-diphenyl-1,10-phenanthroline) | 3.2 | 10.6 | 10.4 | 7.1 |
| M2 (2,4,7,9-tetraphenyl-1,10-phenanthroline) | 4.0 | 10 | 7.7 | 7.3 |
| M3 (Tris(8-hydroxyquinolinato)aluminium) | 4.5 | 6.3 | 4.1 | 3.9 |
| M4 (4-(naphthalen-1-yl)-2,7,9-triphenylpyrido[3,2-h]quinazoline) | 4.4 | 9.4 | 6.7 | 6.6 |
| M5 | 3.9 | 5.0 | 3.6 | 3.0 |
| M6 (4,4'-bis(4,6-diphenyl-1,3,5-triazin-2-yl)biphenyl) | 3.7 | 3.5 | 2.6 | 2.4 |

An overview of the performance of the different Electron transport materials in the above generic stack with LIQ injection layer is given in table 1 above. All OLEDs emit blue light with color coordinates of (0.14; 0.20). As seen from the last column of the table, the Electron transport materials M2, M1 and M4 lead to approximately the same external quantum efficiency, whereas M6, M3 and M5 show reduced quantum efficiency. Thus, already independent of the driving voltage the last three materials are much less suited for OLED application as compared to the three materials from the first group. The driving voltage on the other hand side is much lower for M1 as compared to either M2 or M4. In consequence the external power efficiency is strongly reduced for M2 and M4 as compared to M1. In conclusion, M1 with LiQ injection layer, delivers the outstanding combination of low voltage and high internal quantum efficiency.

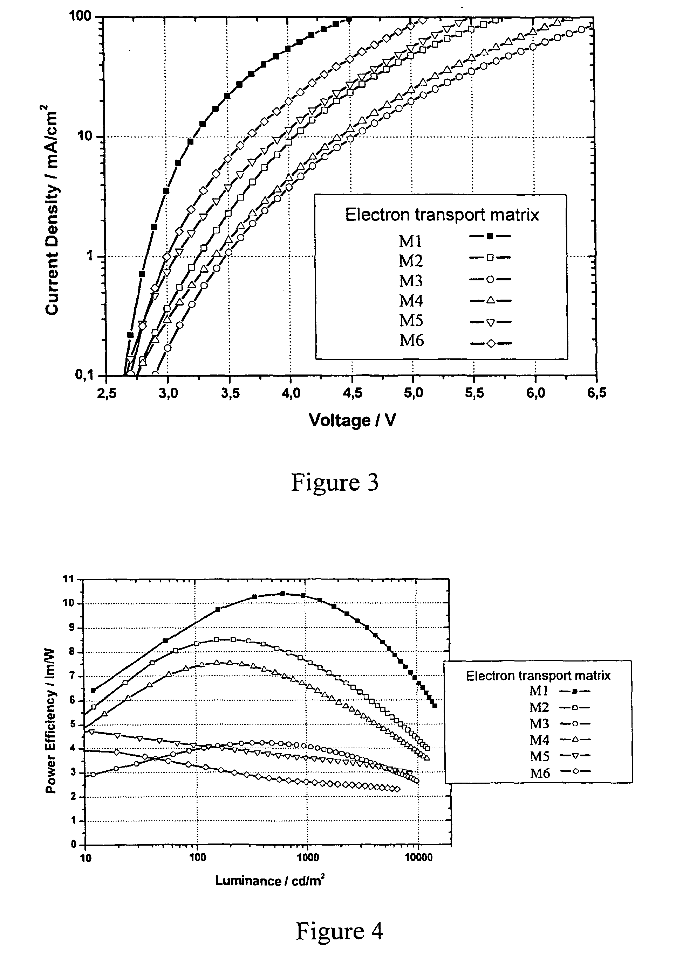

For further visualization, figure 3 shows the current density as a function of the voltage of the OLEDs using various electron transport materials employing in the above generic structure. Obviously, in this direct comparison the typical electron transport material M3/LiQ shows a rather high voltage of 4.5 V. Compared to this M1 / LiQ achieves a voltage of just 3.2 V, which is a very low value for a blue OLED. Relative to this voltage the second best material, M6, already consumes 3.7 V, i.e. 0.5 V more. Thus, even at constant internal efficiency, the external power efficiency would be reduced by 15% relative to the solution with M1/LiQ. However, as seen from the figure 4 below, some of the ETLs, namely M5 and M6 on top of the increased voltage also lead to lower internal efficiency, for example measured by the QEff, in table 3 above. Thus, these materials are in any case not well suited for OLED application.

### Example 2: M1:LIQ

Generic OLED stack: glass / ITO (90nm) / p-dopant:NPD (30nm, 3 wt%) / NPD (10nm) /blue doped Emitter layer (20nm) / M1:LiQ (36nm, 10, 20, or 40wt%) / LIQ (0 or 1 nm) /Aluminum (100 nm) (NDP=N,N'-Bis(naphthalene-1-yl)-N,N"-bis(phenyl)-benzidine)

**Table 2.**

| Concentration wt% | Thickness of pure LiQ layer | Voltage at 10 mA/cm^2 | Current Efficiency (cd/A) at 1000 cd/m^2 | Power Efficiency (lm/W) at 1000 cd/m^2 | Quantum efficiency/% at 1000 cd/m^2 |
|---|---|---|---|---|---|
| 10 | 0 | 3.7 | 5.2 | 4.2 | 4.9 |
| 10 | 0 | 3.77 | 5.2 | 4.1 | 4.7 |
| 10 | 1 | 3.96 | 5.2 | 3.8 | 4.75 |
| 10 | 1 | 3.95 | 5.2 | 3.9 | 4.9 |
| 20 | 0 | 3.76 | 5.2 | 4.1 | 4.75 |
| 20 | 0 | 3.8 | 5.1 | 4.0 | 4.6 |
| 20 | 1 | 3.9 | 5.15 | 3.9 | 4.7 |
| 20 | 1 | 3.8 | 5.1 | 3.9 | 4.7 |
| 40 | 0 | 3.8 | 5.3 | 4.1 | 4.9 |
| 40 | 0 | 3.8 | 5.4 | 4.1 | 4.9 |
| 40 | 1 | 3.9 | 5.3 | 4.0 | 4.9 |
| 40 | 1 | 3.9 | 5.3 | 4.0 | 5.0 |

| | | | | | |
|---|---|---|---|---|---|
| All data with M1 as ETM and 8-hydroxyquinolinolato lithium (LiQ) as EIM. | | | | | |

An overview of the performance of several OLEDs according to the generic stack given above are shown in Table 2. The OLEDs emit deep blue light around 470 nm.

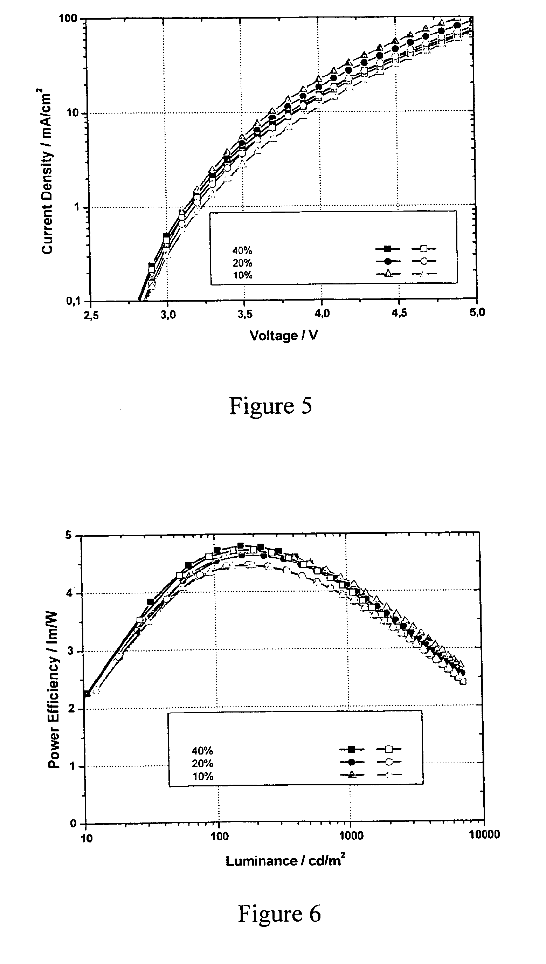

Figure 5 shows the Current-voltage characterisitics of the generic OLED stack, both as a function of LIQ concentration in the M1 electron transport matrix and with and without an 1 nm LiQ electron injection layer present. In all cases is the driving voltage of the OLED at the typical current density of 10 mA/cm² only ∼3.6V, i.e. very low. Thus, especially at higher LiQ doping concentration, the presence of the additional LiQ interlayer only leads to minor further improvments in the driving voltage. In other words it is sufficient to use just a M1 :LiQ mixed layer. Furthermore, the driving voltage is very robust against LiQ doping concentration, which is an important benefit in production.

Figure 6 depicts the Power Efficiency of the different OLEDs shown in Figure 5 as a function of Luminance. The Power efficiency is a good measure for OLED performance, as it combine the effects of different driving voltage with internal efficiency. However, we observe only minor differences whether either an additional LiQ interlayer of 1 nm is used or not or whether the LiQ concentration in the electron transport matrix M1 is 10 or 40%. Thus, over a wide range of LiQ concentration in M1 as well as without additional LiQ interlayer, the M1:LiQ electron transport system leads to the same internal efficiency as well as to the same voltage for this OLED.

### Part list

- OLED: - Organic light emitting diode
- EIL: - Electron injecting layer
- ETL: - Electron transporting layer
- HTL: - Hole transporting layer
- HIL: - Hole injecting layer
- EIM: - Electron injecting material
- ETM: - Electron transporting material
- HTM: - Hole transporting material
- HIM: - Hole injecting material
- EML: - Light emitting layer
- p:HTL: - p-doped HTL
- n:ETL: - n-doped ETL

The features disclosed in the foregoing description, in the claims and in the drawings may, both separately and in any combination thereof, be material for realizing the invention in diverse forms thereof.

## Claims

1. An organic semiconducting layer (11a, 11b) comprising an electron transport material according to Formula (1) 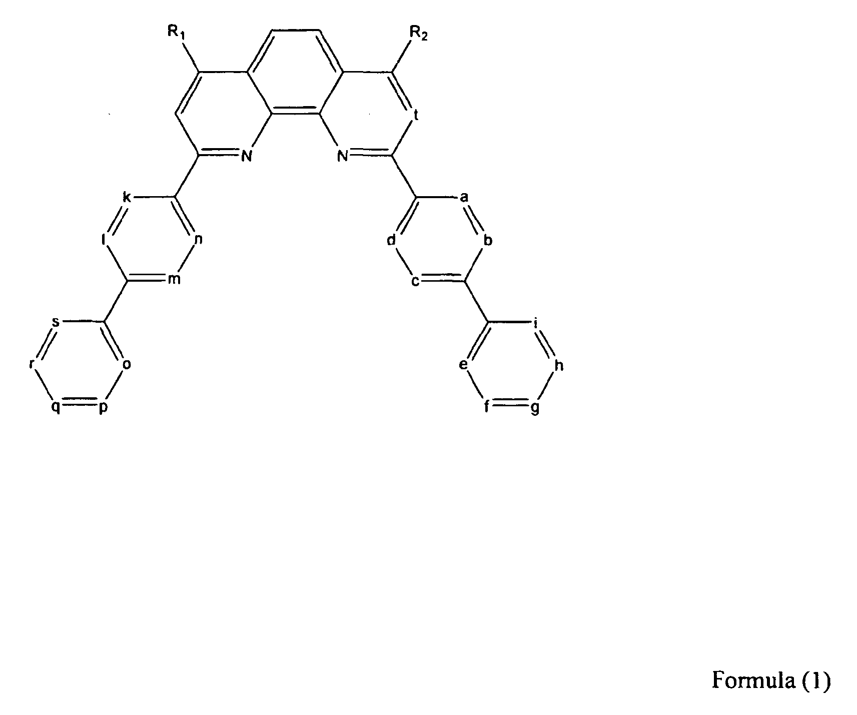
- wherein R1 and R2 are independently selected from H, C1-C20-Alkyl, branched C4-C20-Alkyl or C3-C20-Cycloalkyl, C1-C20 Alkenyl, C1-C20 Alkinyl, Aryl preferably selected from phenyl, tolyl, biphenylyl, naphthyl, or heteroaryl preferably selected from pyridyl, pyrimidinyl, quinolinyl, pyrazinyl, thiophenyl, furanyl, benzothiophenyl, benzofuranyl;
- wherein the structural elements a-s are independently selected from CR3 or N wherein R3 is selected from H, C1-C20-Alkyl or branched C4-C20-Alkyl, C3-C20-Cycloalkyl Alkenyl with C₁-C₂₀, Alkinyl with C₁-C₂₀, Aryl, Heteroaryl, -Hal, -CN, - NO2, -NR4R5 wherein R₄, R5 are independently selected from H, C1-C20-Alkyl or branched C4-C20-alkyl, C1-C20-Cycloalkyl, Alkenyl with C₁-C₂₀, Alkinyl with C₁-C₂₀, Aryl or Heteroaryl, -OR6 or SR6 wherein R₆ is selected from H, C1-C20-Alkyl or branched C4-C20-alkyl C3-C20-Cycloalkyl, Alkenyl with C₁-C₂₀, Alkinyl with C₁-C₂₀, Aryl or Heteroaryl, COOR7 wherein R₇ is selected from H, C1-C20-Alkyl or branched C4-C20-alkyl, C3-C20-Cycloalkyl, Alkenyl with C₁-C₂₀, Alkinyl with C₁-C₂₀, Aryl or Heteroaryl;
- wherein a=b, 1=k, f=g, h=i, p=q, r=s can be replaced by -O-, -S-, NR8 wherein R8 is selected from H, C1-C20-Alkyl or branched C4-C20-alkyl, C3-C20-Cycloalkyl, Alkenyl with C₁-C₂₀, Alkinyl with C₁-C₂₀, Aryl or Heteroaryl;
- wherein the structural element t is selected from CR3;
and an electron injecting material according to Formula (2) 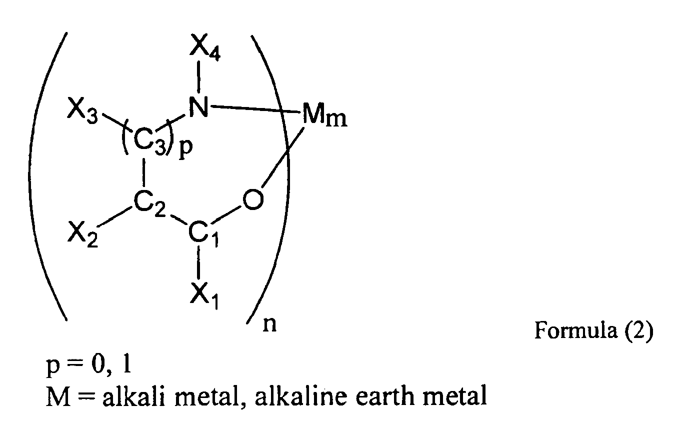
- wherein C₁, C₂ and C₃ are carbon atoms and X₁-X₄ in formula (2) are independently selected from H, heteroatom, C1-C20-alkyl or branched C4-C20-alkyl, C3-C20-cycloalkyl, Alkenyl with C₁-C₂₀, Alkinyl with C₁-C₂₀, Aryl or Heteroaryl,
- wherein m and n are integers independently selected to provide a neutral charge on the complex,
- wherein X₁-C₁-C₂-X₂, X₂-C₂-C₃-X₃ and X₃-C₃-N-X₄ are at the same time or independently from each other part of a fused or nonfused saturated, nonsaturated, aromatic or heteroaromatic polycyclic system,
- preferably is p=0 and X₁-C₁-C₂-X₂ and X₂-C₂-N-X₄ are part of a substituted or non-substituted quinoline structure.

2. Organic semiconducting layer according to claim 1 wherein the electron injecting material is provided in the electron transport material as a mixed layer (11a), and the electron transport material is the main component of the layer (11a).

3. Organic semiconducting layer according to claim 1 wherein the electron injecting material and the electron transport material are spatially separated into two adjacent sublayers (11a, 11b).

4. Organic semiconducting layer according to claim 3 wherein the electron injecting material is also provided in the electron transport material as a mixed layer (11a), and the electron transport material is the main component of the mixed layer (11a).

5. Organic semiconducting layer according to any of the preceding claims, wherein the electron transport layer (11a) has a thickness between 5 nm and 70 nm.

6. Organic semiconducting layer according to claim 1,3,4 or 5, wherein the electron injecting layer (11a) has a thickness between 0.5 nm and 3 nm.

7. Organic semiconducting layer according to any one of the preceding claims wherein the electron transporting material is chosen from Formula (1a) 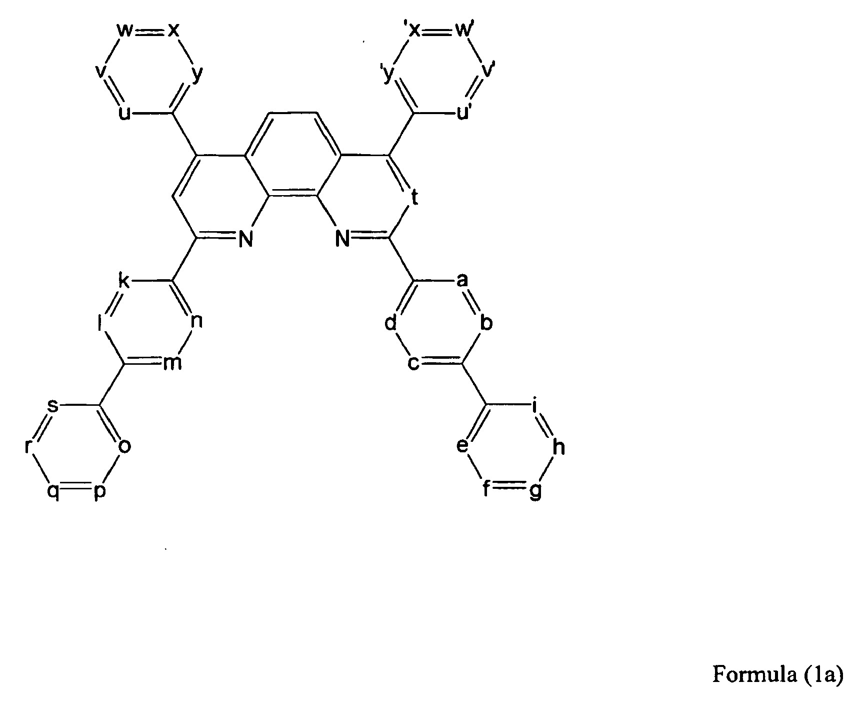
- wherein the structural elements a-s are as defined in claim 1;
- wherein a=b, 1=k, f=g, h=i, p=q, r=s are as defined in claim 1;
- wherein the structural element t is selected from CR3 as defined in claim 1;
- wherein the structural elements v,u,x,y and v',w',x',y' are independently selected from CR3 or N;
- wherein u=v, w=x, u'=v', w'=x' can be replaced by -0-, -S- or NR8 wherein R8 is as defined in claim 1.

8. Organic semiconducting layer according to any one of the preceding claims wherein the electron transporting material is chosen from Formula (1b) 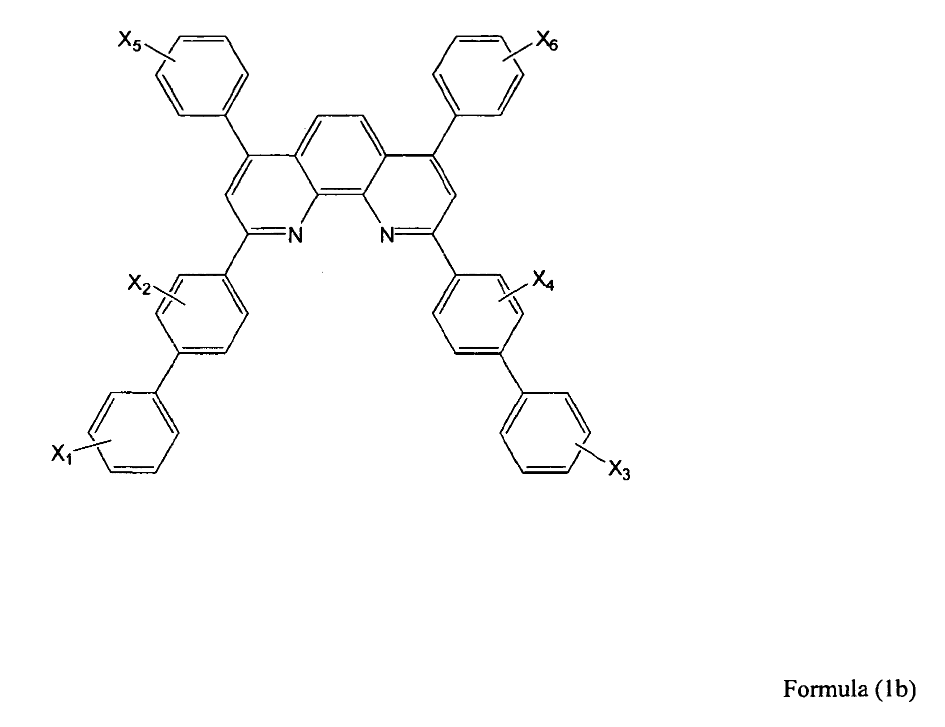
- wherein the structural elements X1-X6 in Formula (1b) are independently selected from H, C1-C20-Alkyl, branched C4-C20-Alkyl or C3-C20-Cycloalkyl, C1-C20-Alkenyl, C1-C20-Alkinyl, Aryl preferably selected from phenyl, tolyl, biphenylyl, naphthyl, or heteroaryl preferably selected from pyridyl, pyrimidinyl, quinolinyl, pyrazinyl, thiophenyl, furanyl, benzothiophenyl, benzofuranyl;

9. Organic semiconducting layer according to any one of the preceding claims wherein the electron transporting material is 2,9-di(biphenyl-4-yl)-4,7-diphenyl-1,10-phenanthroline.

10. Organic semiconducting layer according to any one of the preceding claims wherein the electron injecting material is 8-hydroxyquinolinolato lithium.

11. A layer sequence comprising the organic semiconducting layer according to any one of the preceding claims **characterized in that** a metal cathode (24) is provided in direct contact with the electron injecting material.

12. Layer sequence according to claim 11 **characterized in that** the metal cathode (24) comprises at least one of the following materials Ca, Mg, Ba, or Al as its main component.

13. OLED comprising an emitter layer (21) and a layer sequence as in claims 11 or 12 or an organic semiconducting layer (11a, 11b) as in any of the preceding claims 1 to 10.

14. OLED according to claim 13 wherein the OLED is a non-inverted device, comprising an anode (21) provided over a substrate (20), an emitter layer (22) provided over the anode (21), the organic semiconducting layer (23) according to any of the claims 1-10 provided over the emitter layer (22), and a cathode (24) provided over the organic semiconducting layer (23).

## Patentansprüche

1. Organische Halbleiterschicht (11a, 11b), umfassend ein Elektronentransportmaterial nach Formel (1) 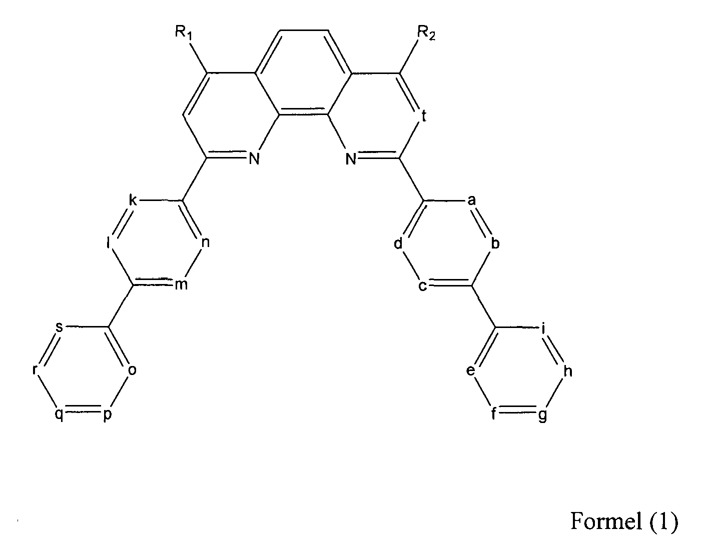
- wobei R1 und R2 unabhängig ausgewählt sind aus H, C1-C20-Alkyl, verzweigtem C4-C20-Alkyl oder C3-C20-Cycloalkyl, C1-C20-Alkenyl, C1-C20-Alkinyl, Aryl, bevorzugt ausgewählt aus Phenyl, Tolyl, Biphenylyl, Naphthyl, oder Heteroaryl, bevorzugt ausgewählt aus Pyridyl, Pyrimidinyl, Chinolinyl, Pyrazinyl, Thiophenyl, Furanyl, Benzothiophenyl, Benzofuranyl;
- wobei die Strukturelemente a-s unabhängig ausgewählt sind aus CR3 oder N, wobei R3 ausgewählt ist aus H, C1-C20-Alkyl oder verzweigtem C4-C20-Alkyl, C3-C20-Cycloalkyl, Alkenyl mit C1-C20, Alkinyl mit C1-C20, Aryl, Heteroaryl, -Halogen, -CN, -NO2, -NR4R5, wobei R4, R5 unabhängig ausgewählt sind aus H, C1-C20-Alkyl oder verzweigtem C4-C20-Alkyl, C1-C20-Cycloalkyl, Alkenyl mit C1-C20, Alkinyl mit C1-C20, Aryl oder Heteroaryl, -OR6 oder SR6, wobei R6 ausgewählt ist aus H, C1-C20-Alkyl oder verzweigtem C4-C20-Alkyl, C3-C20-Cycloalkyl, Alkenyl mit C1-C20, Alkinyl mit C1-C20, Aryl oder Heteroaryl, COOR7, wobei R7 ausgewählt ist aus H, C1-C20-Alkyl oder verzweigtem C4-C20-Alkyl, C3-C20-Cycloalkyl, Alkenyl mit C1-C20, Alkinyl mit C1-C20, Aryl oder Heteroaryl;
- wobei a=b, 1=k, f=g, h=i, p=q, r=s ersetzt sein kann durch -O-, -S-, NR8, wobei R8 ausgewählt ist aus H, C1-C20-Alkyl oder verzweigtem C4-C20-Alkyl, C3-C20-Cycloalkyl, Alkenyl mit C1-C20, Alkinyl mit C1-C20, Aryl oder Heteroaryl;
- wobei das Strukturelement t ausgewählt ist aus CR3;
- und ein Elektroneninjektionsmaterial nach Formel (2) 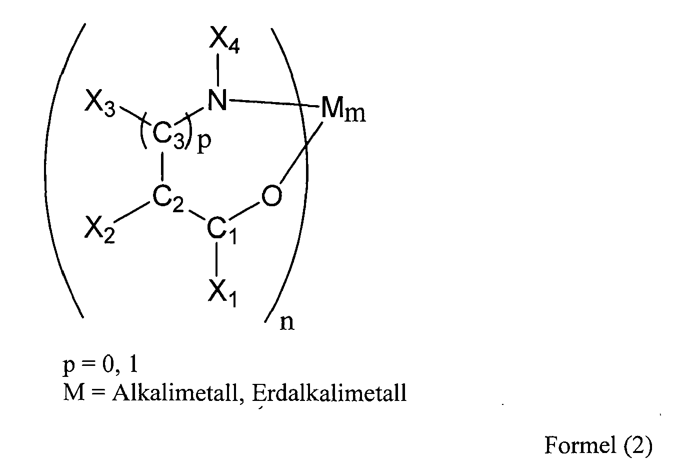
- wobei C1, C2 und C3 Kohlenstoffatome sind und X1-X4 in Formel (2) unabhängig ausgewählt sind aus H, Heteroatom, C1-C20-Alkyl oder verzweigtem C4-C20-Alkyl, C3-C20-Cycloalkyl, Alkenyl nmit C1-C20, Alkinyl mit C1-C20, Aryl oder Heteroaryl,
- wobei m und n ganze Zahlen sind, unabhängig ausgewählt, um eine neutrale Ladung für den Komplex bereitzustellen,
- wobei X₁-C₁-C₂-X₂, X₂-C₂-C₃-X₃ und X₃-C₃-N-X₄ gleichzeitig oder unabhängig voneinander Teil eines kondensierten oder nicht-kondensierten, gesättigten, ungesättigten, aromatischen oder heteroaromatischen polycyclischen Systems sind,
bevorzugt p=0 ist und X₁-C₁-C₂-X₂ und X₂-C₂-N-X₄ Teil einer substituierten oder nicht-substituierten Chinolinstruktur sind.

2. Organische Halbleiterschicht nach Anspruch 1, wobei das Elektroneninjektionsmaterial in dem Elektronentransportmaterial als eine gemischte Schicht (11a) bereitgestellt ist und das Elektronentransportmaterial die Hauptkomponente der Schicht (11a) ist.

3. Organische Halbleiterschicht nach Anspruch 1, wobei das Elektroneninjektionsmaterial und das Elektronentransportmaterial räumlich in zwei benachbarte Unterschichten (11a, 11b) getrennt sind.

4. Organische Halbleiterschicht nach Anspruch 3, wobei das Elektroneninjektionsmaterial ebenfalls in dem Elektronentransportmaterial als eine gemischte Schicht (11a) bereitgestellt ist und das Elektronentransportmaterial die Hauptkomponente der gemischten Schicht (11a) ist.

5. Organische Halbleiterschicht nach einem der vorangehenden Ansprüche, wobei die Elektronentransportschicht (11a) eine Dicke zwischen 5 nm und 70 nm aufweist.

6. Organische Halbleiterschicht nach Anspruch 1, 3, 4 oder 5, wobei die Elektroneninjektionsschicht (11a) eine Dicke zwischen 0,5 nm und 3 nm aufweist.

7. Organische Halbleiterschicht nach einem der vorangehenden Ansprüche, wobei das Elektronentransportmaterial aus Formel (1a) ausgewählt ist 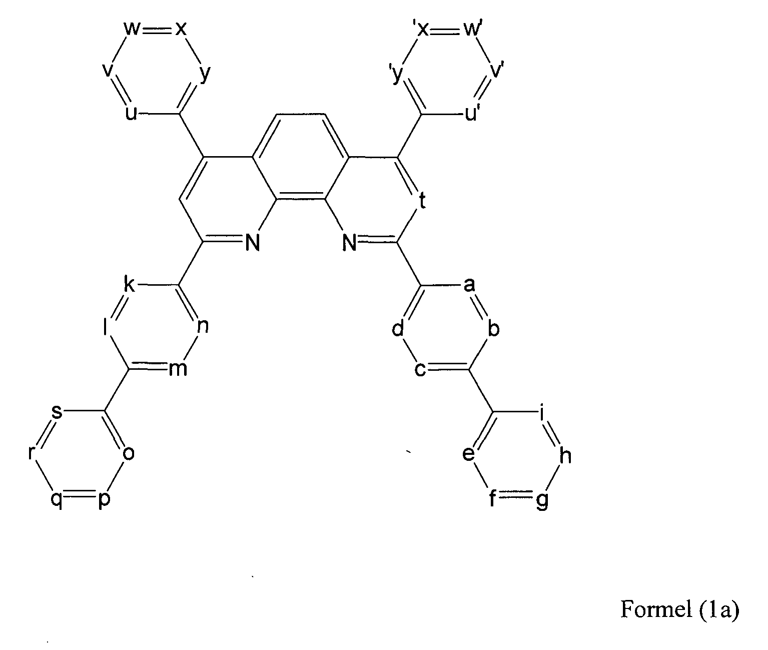
- wobei die Strukturelemente a-s wie in Anspruch 1 definiert sind;
- wobei a=b, 1=k, f=g, h=i, p=q, r=s wie in Anspruch 1 definiert sind;
- wobei das Strukturelement t ausgewählt ist aus CR3, wie in Anspruch 1 definiert;
- wobei die Strukturelemente v, u, x, y und v', w', x', y' unabhängig ausgewählt sind aus CR3 oder N;
- wobei u=v, w=x, u'=v', w'=x' ersetzt sein können durch -O-, -S- oder NR8, wobei R8 wie in Anspruch 1 definiert ist.

8. Organische Halbleiterschicht nach einem der vorangehenden Ansprüche, wobei das Elektronentransportmaterial ausgewählt ist aus Formel (1b) 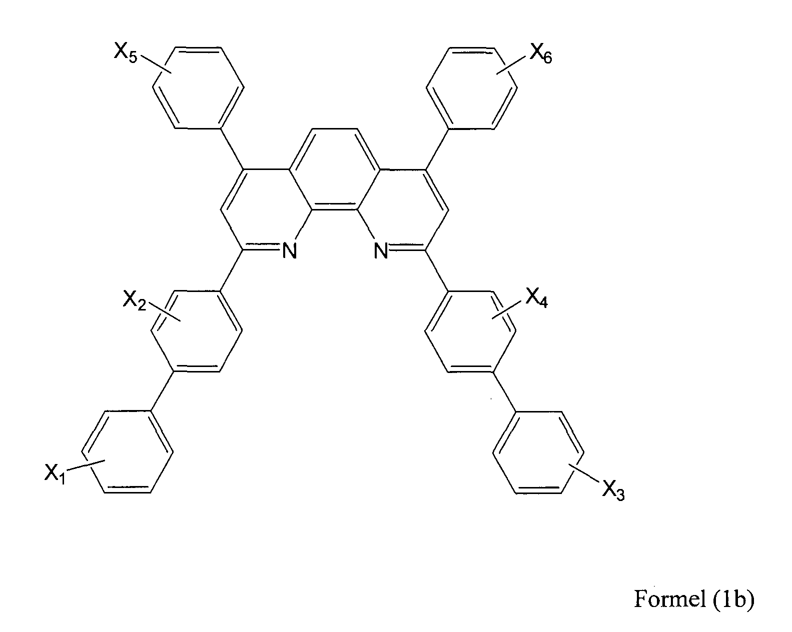
- wobei die Strukturelemente X1-X6 in Formel (1b) unabhängig ausgewählt sind aus
- H, C1-C20-Alkyl, verzweigtem C4-C20-Alkyl oder C3-C20-Cycloalkyl, C1-C20-Alkenyl, C1-C20-Alkinyl, Aryl, bevorzugt ausgewählt aus Phenyl, Tolyl, Biphenylyl, Naphthyl, oder Heteroaryl, bevorzugt ausgewählt aus Pyridyl, Pyrimidinyl, Chinolinyl, Pyrazinyl, Thiophenyl, Furanyl, Benzothiophenyl, Benzofuranyl;

9. Organische Halbleiterschicht nach einem der vorangehenden Ansprüche, wobei das Elektronentransportmaterial 2,9-Di(biphenyl-4-yl)-4,7-diphenyl-1,10-phenanthrolin ist.

10. Organische Halbleiterschicht nach einem der vorangehenden Ansprüche, wobei das Elektroneninjektionsmaterial 8-Hydroxychinolinolatolithium ist.

11. Schichtsequenz umfassend die organische Halbleiterschicht nach einem der vorangehenden Ansprüche, **dadurch gekennzeichnet, dass** eine Metallkathode (24) in direktem Kontakt mit dem Elektroneninjektionsmaterial bereitgestellt ist.

12. Schichtsequenz nach Anspruch 1, **dadurch gekennzeichnet, dass** die Metallkathode (24) wenigstens eines der folgenden Materialien Ca, Mg, Ba oder al als ihre Hauptkomponente umfasst.

13. OLED umfassend eine Emitterschicht (21) und eine Schichtsequenz nach Anspruch 11 oder 12 oder eine organische Halbleiterschicht (11a, 11b) nach einem der vorangehenden Ansprüche 1 bis 10.

14. OLED nach Anspruch 13, wobei die OLED eine nicht-invertierte Vorrichtung ist, umfassend eine Anode (21) bereitgestellt über einem Substrat (20), eine Emitterschicht (22) bereitgestellt über der Anode (21), die organische Halbleiterschicht (23) nach einem der Ansprüche 1-10 bereitgestellt über der Emitterschicht (22) und eine Kathode (24) bereitgestellt über der organischen Halbleiterschicht (23).

## Revendications

1. Couche semi-conductrice organique (11a, 11b) comprenant un matériau de transport d'électrons selon la formule (1) 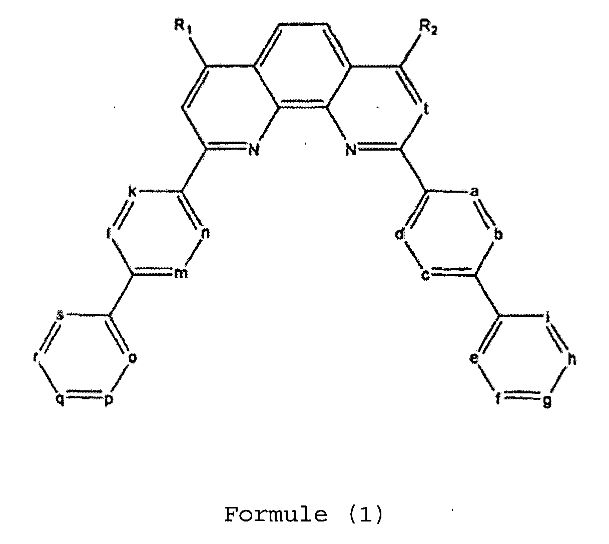
- où R1 et R2 sont choisis indépendamment de H, alkyle en C1-C20, ramifié en C4-C20-alkyle ou C3-C20-Cycloalky], alcényle en C1-C20, alcynyle en C1-C20, aryle de préférence choisi parmi les groupes phényle, tolyle, biphénylyle, naphtyle ou hétéroaryle, de préférence choisi parmi les groupes pyridyle, pyrimidinyle, quinolinyle, pyrazinyle, thiophényle, furanyle, benzothiophényle, benzofuranyle ;
- où les éléments de structure comme a-s sont indépendamment choisis entre CR3 ou N, avec R3 choisi de H, alkyle en C1-C20 ou ramifié en Alkyle en C4-C20, cycloalkyle en C3-C20, alcényle en C₁-C₂₀, alcynyle en C₁-C₂₀, aryle, hétéroaryle,-Hal,-CN,-N02,-NR4R5 avec R₄, R5 indépendamment choisis de H, alkyle en C1-C20 ou ramifié en aryle en C4-C20, cycloalkyle en C1-C20, alcényle en C₁- C₂₀, alkinyle en C₁-C₂₀, aryle ou hétéroaryle,-OR6 ou SR6 avec R₆ choisi de H, alkyle en C1-C20 ou ramifié en alkyle en C4-C20, cycloalkyle en C3-C20, alcényle en C₁-C₂₀, alcynyle en C₁-C₂₀, aryle ou hétéroaryle, COOR7 avec R₇ choisi de H, alkyle en C1-C20 ou ramifié en alkyle en C4-C20, cycloalkyle en C3-C20, alcényle en C₁-C_{20,} alcynyle en C₁-C₂₀, aryle ou hétéroaryle ;
- où a=b, 1=k, f=g, h=i, p=q, r=s pouvant se remplacer par -0-, -S-, NR8 où R8 est choisi de H, alkyle en C1-C20-Alkyl ou ramifié en alkyle en C4-C20, cycloalkyle en C3-C20, alcénile avec C₁-C₂₀, alcynyle avec C₁-C₂₀, aryle ou hétéroaryle ;
- où l'élément de structure t est choisi de CR3 ;
et un matériau d'injection d'électrons selon la formule (2) 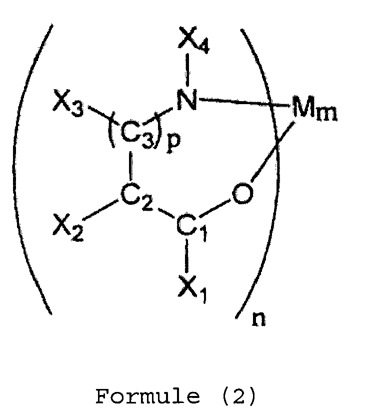 p = 0, 1
M = métal alcalin, métal alcalino-terreux
- où C₁, C₂ et C₃ sont des atomes de carbone et X₁-X₄ dans la formule (2) sont indépendamment choisis de H, un hétéroatome, alkyle en C1-C20 ou ramifié en alkyle en C4-C20, cycloalkyle en C3-C20, un groupe alcényle en C₁-C₂₀, alcynyle en C₁-C₂₀, aryle ou hétéroaryle,
- où m et n sont des nombres entiers choisis indépendamment pour fournir une charge neutre sur le complexe,
- où X₁-C₁-C₂-X₂, X₂-C₂-C₃-X₃ et X₃-C₃-N-X₄ sont en même temps ou de manière indépendante l'une de l'autre partie d'un système polycyclique fusionné ou non fusionné saturé, non saturé, aromatique ou hétéroaromatique,
- de préférence p=0 et X₁-C₁-C₂-X₂ et X₂-C₂-N-X₄ et font partie d'une structure substituée ou non substituée quinoléine.

2. Couche semi-conductrice organique selon la revendication 1, où le moyen d'injection de l'électron est fourni dans le matériau de transport d'électrons en tant que couche de mélange (lla), et le matériau de transport de l'électron est le composant principal de la couche (11a) .

3. Couche semi-conductrice organique selon la revendication 1, où le moyen d'injection de l'électron et le matériau de transport d'électrons sont séparés spatialement en deux sous-couches voisines (11a, 11b).

4. Couche semi-conductrice organique selon la revendication 3, où le moyen d'injection de l'électron est également fourni dans le matériau de transport d'électrons en tant que couche de mélange (11a), et le matériau de transport de l'électron est le composant principal de la couche mixte (11a).

5. Couche semi-conductrice organique selon l'une quelconque des revendications précédentes, où la couche de transport d'électrons (11a) a une épaisseur comprise entre 5 nm et 70 nm.

6. Couche semi-conductrice organique selon les revendications 1 , 3 , 4 ou 5, où la couche d'injection d'électrons (11a) a une épaisseur entre 0,5 nm et 3 nm.

7. Couche organique semi-conductrice selon l'une quelconque des revendications précédentes où le matériau de transport d'électrons est choisi de la formule (1a) 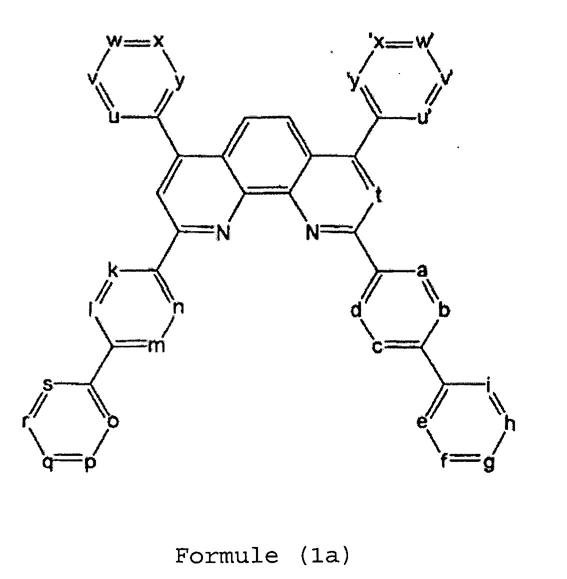
- où les éléments de structure sont tels que définis dans la revendication 1 ;
- où a=b, i=k, f=g, h=i, p=q, r=s étant tels que défini dans la revendication 1 ;
- où l'élément de structure t est choisi de CR3 tel que défini dans la revendication 1 ;
- où les éléments structurels v, u, x, y et v', w', x', y' sont choisis indépendamment de CR3 ou N ;
- où u=v, w=x, u'=v', w'=x' peut être remplacé par-O-,-S-ou NR8 avec R8 tel que défini dans la revendication 1.

8. Couche organique semi-conductrice selon l'une quelconque des revendications précédentes où le matériau de transport d'électrons est choisi de la formule (1b) 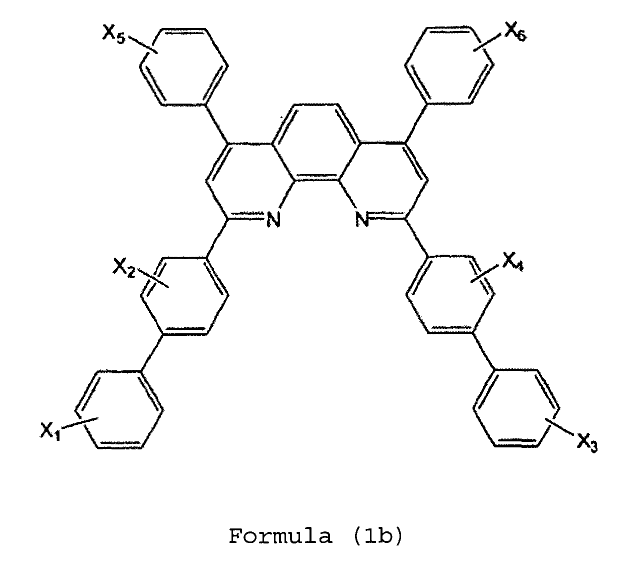
- où les éléments structuraux X1-X6 de la formule (1b) sont choisis indépendamment de H, alkyle en C1-C20, ramifié en C4-C20-alkyle ou C3-C20-Cycloalky], alcényle en C1-C20, alcynyle en C1-C20, aryle de préférence choisi parmi les groupes phényle, tolyle, biphénylyle , naphtyle ou hétéroaryle, de préférence choisi parmi les groupes pyridyle, pyrimidinyle, quinolinyle, pyrazinyle, thiophényle, furanyle, benzothiophényle, benzofuranyle ;

9. Couche semi-conductrice organique selon l'une quelconque des revendications précédentes, où le matériau de transport d'électrons est 2,9-di (biphényl-4-yl) -4,7-diphényl-1 ,10-phénanthroline.

10. Couche semi-conductrice organique selon l'une quelconque des revendications précédentes, où le matériau d'injection d'électrons est le 8-hydroxyquinolinolato lithium.

11. Succession de couches comprenant la couche de semiconducteur organique selon l'une quelconque des revendications précédentes, où une cathode métallique (24) est prévue en contact direct avec le matériau d'injection d'électrons.

12. Séquence de couches selon la revendication 11, où la cathode métallique (24) comprend au moins l'un des matériaux suivants Ca, Mg, Ba, Al ou son composant principal.

13. OLED comprenant une couche d'émetteur (21) et une séquence de couches selon les revendications 11 ou 12 où une couche semi-conductrice organique (11a, 11b) selon l'une quelconque des revendications précédent les revendications 1 à 10.

14. OLED selon la revendication 13, l'OLED étant un dispositif non-inversé, comprenant une anode (21) prévue sur un substrat (20), une couche d'émetteur (22) prévu sur l'anode (21), la couche semi-conductrice organique (23) selon l'une quelconque des revendications 1 à 10 prévues sur la couche d'émetteur (22) et une cathode (24) prévue sur la couche du semiconducteur organique (23).
